# EUROPÄISCHE PATENTSCHRIFT

(11) **EP 1 099 258 B1**
(45) Veröffentlichungstag und Bekanntmachung des Hinweises auf die Patenterteilung: **14.08.2013**
(21) Anmeldenummer: 99939952.0
(22) Anmeldetag: 25.06.1999
(51) Int. Cl.: H01L 33/00

(54) **LICHTQUELLE ZUR ERZEUGUNG SICHTBAREN LICHTS**
LIGHT SOURCE FOR GENERATING VISIBLE LIGHT
SOURCE LUMINEUSE POUR LA PRODUCTION DE LUMIERE VISIBLE

(30) Priorität: 30.06.1998 DE 19829208
(43) Veröffentlichungstag der Anmeldung: 16.05.2001
(73) Patentinhaber: OSRAM Opto Semiconductors GmbH, 93055 Regensburg (DE)
(72) Erfinder: TEWS, Helmut, Poughkeepsie, NY 12603 (US); AVERBECK, Robert, D-81371 München (DE); RIECHERT, Henning, D-85521 Riemerling (DE)
(74) Vertreter: Epping - Hermann - Fischer
(86) Internationale Anmeldenummer: PCT/DE1999/001860
(87) Internationale Veröffentlichungsnummer: WO 2000/002261

(56) Entgegenhaltungen:
- WO-A-97/48138
- US-A- 3 875 456
- PATENT ABSTRACTS OF JAPAN vol. 1997, no. 10, 31. Oktober 1997 (1997-10-31) & JP 09 153645 A (TOYODA GOSEI CO LTD;AKASAKI ISAMU; AMANO HIROSHI), 10. Juni 1997 (1997-06-10)
- SHIBATA M ET AL: "GaN/BAlN heterostructure grown on a (0001)6H-SiC substrate by metalorganic vapor phase epitaxy" SECOND INTERNATIONAL CONFERENCE ON NITRIDE SEMICONDUCTORS, TOKUSHIMA, JAPAN, 27-31 OCT. 1997, Bd. 189-190, Seiten 445-447, XP004148551 Journal of Crystal Growth, June 1998, Elsevier, Netherlands ISSN: 0022-0248

## Beschreibung

Die Erfindung betrifft eine Lichtquelle zur Erzeugung sichtbaren Lichts gemäß Oberbegriff des Patentanspruches 1 oder Oberbegriff des Patentanspruches 5.

Aus der Internationalen Patentanmeldung WO 97/48138 ist eine Lichtquelle zur Erzeugung sichtbaren Lichts bekannt, die aus zumindest einer ultraviolettes Licht emittierenden Diode auf Halbleiterbasis und zumindest einem Leuchtstoff besteht, in den das emittierte ultraviolette Licht eingestrahlt wird und der aus dem emittierten ultravioletten Licht das sichtbare Licht erzeugt.

Die US-Patentschrift US 3,875,456 beschreibt eine Halbleiter-Lichtquelle, die mehr als eine Halbleiterdiode enthält. Die Halbleiterdioden können infrarote Strahlung aussenden, die mit einem Leuchtstoff in sichtbares Licht umgewandelt wird, wobei zwei voneinander verschiedene Leuchtstoffe verwendet werden können.

Aus M. Shibata et al., "GaN/BAlN heterostructure grown on a (0001)6H-SiC substrate by metalorganic vapour phase epitaxy", Journal of Crystal Growth 189/190 (1998) 445-447, ist eine GaN/BAlN-Heterostruktur bekannt, die ultraviolette Strahlung emittiert.

Eine Lichtquelle, die aus einer Licht einer bestimmten Wellenlänge emittierenden Diode auf Halbleiterbasis und zumindest einem Leuchtstoff besteht, in den das emittierte Licht einstrahlt und der aus dem eingestrahlten Licht sichtbares Licht einer anderen Wellenlänge erzeugt, ist bekannt und wird von der Siemens AG mit Sitz in Berlin und München unter der Handelsmarke LUCO^{®} angeboten. Bei dieser Lichtquelle besteht die Diode aus einer Leuchtdiode, die blaues Licht emittiert. Der Leuchtstoff erzeugt Licht im gelben Spektralbereich durch Absorption des emittierten blauen Lichts. Das von dieser Lichtquelle abgegebene Licht ist weißes Licht, das sich durch Überlagerung des im gelben Spektralbereich erzeugten Lichts und eines nicht absorbierten Anteils des emittierten blauen Lichts ergibt.

Die bekannte Lichtquelle hat einen hohen Wirkungsgrad, ist baulich einfach, klein in den Abmessungen, billig, und benötigt eine nur geringe elektrische Betriebsspannung, die einen Batteriebetrieb ermöglicht.

Es ist auch eine Lichtquelle zur Erzeugung sichtbaren Lichts mit Hilfe einer Diode auf Halbleiterbasis bekannt, die aus drei Leuchtdioden besteht, von denen eine erste nur die Grundfarbe rot, eine zweite nur die Grundfarbe grün und die dritte nur die Grundfarbe blau emittiert. Diese drei Dioden sind, beispielsweise in einem Gehäuse, so angeordnet, daß sich die drei emittierten Grundfarben überlagern und dadurch weißes Licht erzeugen. Ein Leuchtstoff ist bei dieser Lichtquelle nicht erforderlich.

Auch diese Lichtquelle hat einen hohen Wirkungsgrad und benötigt eine nur geringe elektrische Betriebsspannung, die einen Batteriebetrieb ermöglicht. Allerdings müssen die Intensitäten der drei Grundfarben genau aufeinander abgestimmt sein. Aus diesem Grund und wegen der Notwendigkeit dreier Leuchtdioden und einer aufwendigen Montagetechnik ist diese Lichtquelle im Vergleich zur Lichtquelle der erstgenannten Art aufwendiger und teurer.

Beide Lichtquellen sind im Vergleich zu einer herkömmlichen Leuchtstofflampe, bei der ultraviolettes Licht mit einer Wellenlänge von 253,7 nm aus einer Gasentladung emittiert wird, und die zumindest einen Leuchtstoff aufweist, in den dieses emittierte ultraviolette Licht einstrahlt und der aus diesem eingestrahlten ultravioletten Licht sichtbares Licht erzeugt, baulich einfach und können mit kleinen Abmessungen realisiert werden. Die Gasentladung einer Leuchtstofflampe erfordert eine hohe elektrische Spannung und die Abmessungen der Lampe können konstruktionsbedingt bestimmte Werte nicht unterschreiten. Leuchtstofflampen erreichen einen Wirkungsgrad von etwa 20%, der im Vergleich zum Wirkungsgrad von etwa 4% einer konventionellen Glühlampe hoch ist.

Unter dem Wirkungsgrad ist das Verhältnis aus der von der jeweiligen Lichtquelle abgegebenen optischen Leistung zu der zur Erzeugung dieser Leistung aufgewendeten elektrischen Leistung zu verstehen.

Bei der konventionellen Leuchtstofflampe kann ein Leuchtstoff in Form eines Gemisches aus verschiedenen Leuchtstoffsubstanzen verwendet werden, deren jede bei der Wellenlänge 253,7 nm aktiviert wird und jeweils sichtbares Licht einer Wellenlänge mit einem Spektrum aus mehreren Wellenlängen erzeugen kann.

Der Erfindung liegt die Aufgabe zugrunde, eine Lichtquelle zur Erzeugung sichtbaren Lichts bereitzustellen, bei der zur Bildung eines Spektrums des erzeugten sichtbaren Lichts, ein bedeutend größerer Reichtum an sichtbaren Wellenlängen und/oder Spektren zur Verfügung steht.

Diese Aufgabe wird durch eine Lichtquelle nach Anspruch 1 oder 5 gelöst.

Die erfindungsgemäße Lichtquelle ist eine Quelle der eingangs genannten Art, bei der unter anderem im Unterschied zur bekannten Luco Lichtquelle die Diode nicht sichtbares blaues, sondern unsichtbares ultraviolettes Licht emittiert und der Leuchtstoff das sichtbare Licht aus dem emittierten ultravioletten Licht und nicht aus emittiertem blauen Licht erzeugt.

Das mit der erfindungsgemäßen Lichtquelle erzeugte sichtbare Licht ist vorteilhafterweise frei von einer Überlagerung von Licht einer Farbe und von aus einer Leuchtdiode stammenden Licht einer anderen Farbe.

Bei der erfindungsgemäßen Lichtquelle stammt vorteilhafterweise das erzeugte sichtbare Licht ähnlich wie bei einer konventionellen Leuchtstofflampe allein aus dem Leuchtstoff, da das von der Diode erzeugte ultraviolette Licht unsichtbar ist.

ES kann auβerhalb der Erfindung jede beliebige Diode eingesetzt werden, die ultraviolettes Licht erzeugt, gleichgültig welcher Wellenlänge. Es muß nur ein Leuchtstoff gewählt werden, der bei der ultravioletten Wellenlänge aktiviert wird, die von der jeweiligen Diode erzeugt wird. Mit den derzeit oder zumindest in naher Zukunft zur Verfügung stehenden Dioden können vorteilhafterweise im wesentlichen alle ultravioletten Wellenlängen jenseits der Grenze zum sichtbaren Violett, insbesondere die Wellenlängen von 150 nm bis 400 nm erzeugt werden, so daß alle diese Wellenlängen, die insbesondere auch die Wellenlänge 253,7 nm enthalten, für die Lichtquelle zur Verfügung stehen. Für jede dieser ultravioletten Wellenlängen können eigene, insbesondere auch neue Leuchtstoffe eingesetzt werden, so daß die Palette der verwendbaren Leuchtstoffe im Vergleich zur konventionellen Leuchtstofflampe, vorteilhafterweise ungleich vielfältiger ist.

Bei der konventionellen Leuchtstofflampe ist das ultraviolette Licht auf den sehr schmalbandigen, bei 253,7 nm liegenden Wellenlängenbereich der Gasentladung beschränkt. Entsprechend können bei der Lampe nur Leuchtstoffe eingesetzt werden, die bei der Wellenlänge 253,7 nm aktiviert werden.

Insbesondere kann vorteilhafterweise eine ungleich größere Anzahl Wellenlängen und/oder Spektren des abgegebenen sichtbaren Lichts als bisher realisiert werden, da nicht nur die sichtbaren Wellenlängen und/oder Spektren der bei der einzelnen ultravioletten Wellenlänge 253,7 nm aktivierten Leuchtstoffe, sondern zusätzlich die sichtbaren Wellenlängen und/oder Spektren der Leuchtstoffe, die bei den von 253,7 nm verschiedenen ultravioletten Wellenlängen aktiviert werden, zur Verfügung stehen. Die von den zusätzlich zur Verfügung stehenden Leuchtstoffen erzeugbaren zusätzlichen sichtbaren Wellenlängen und/oder Spektren können untereinander und von den von den bei der einzelnen ultravioletten Wellenlänge 253,7 nm aktivierten Leuchtstoffen erzeugten sichtbaren Wellenlängen vorteilhafterweise sehr verschieden sein. Es steht somit für das erzeugte sichtbare Licht ein beträchtlich größerer Reichtum an sichtbaren Wellenlängen und/oder sichtbaren Spektren zur Verfügung.

Ähnlich wie bei der konventionellen Leuchtstofflampe kann bei der erfindungsgemäßen Lichtquelle vorteilhafterweise ein Leuchtstoff in Form eines Gemisches und/oder Laminats aus verschiedenen Leuchtstoffsubstanzen verwendet werden, die bei ein und derselben ultravioletten Wellenlänge aktiviert werden und bei dieser Wellenlänge mehrere sichtbare Wellenlängen und/oder Spektren, insbesondere verschiedene, z.B. bei mehreren sichtbaren Wellenlängen liegende Spektren, erzeugen können, die zur Bildung eines Spektums des von der erfindungsgemäßen Lichtquelle abgegebenen sichtbaren Lichts zur Verfügung stehen.

Im Unterschied zur konventionellen Leuchtstofflampe, bei der diese Möglichkeit auf die einzelne ultraviolette Wellenlänge 253,7 nm beschränkt ist, besteht bei der erfindungsgemäßen Lichtquelle diese Möglichkeit vorteilhafterweise für Wellenlängen aus dem ultravioletten Bereich, insbesondere dem Bereich von 150 nm bis 400 nm. Demnach können bei der erfindungsgemäßen Lichtquelle sichtbare Wellenlängen und/oder verschiedene, bei sichtbaren Wellenlängen liegende Spektren nicht nur in Abhängigkeit von den verwendeten Gemischen und/oder Laminaten aus verschiedenen Leuchtstoffsubstanzen, sondern zusätzlich in Abhängigkeit von der verwendeten ultravioletten Wellenlänge erzeugt werden, so daß die erfindungsgemäße Lichtquelle im Vergleich mit der konventionellen Leuchtstofflampe sichtbares Licht eines Spektrums abgeben kann, zu dessen Bildung eine ungleich größere Vielfalt an sichtbaren Wellenlängen und/oder sichtbaren Spektren zur Verfügung steht.

Ein Laminat besteht aus mindestens zwei aufeinander angeordneten Schichten aus insbesondere voneinander verschiedenen Substanzen.

Ein besonderer Vorteil der erfindungsgemäßen Lichtquelle ist im Vergleich mit der konventionellen Leuchtstofflampe überdies darin zu sehen, daß mehrere ultraviolette Wellenlängen gleichzeitig verwendet werden können. Dazu muß die erfindungsgemäße Lichtquelle nur mehrere Dioden, deren jede ultraviolettes Licht bei einer anderen Wellenlänge emittiert, und für jede dieser ultravioletten Wellenlängen zumindest einen Leuchtstoff aufweisen, der bei dieser ultravioletten Wellenlänge aktiviert wird.

Demnach ist es bei der erfindungsgemäßen Lichtquelle im Unterschied zur konventionellen Leuchtstofflampe, bei der nur Leuchtstoffe oder Leuchtstoffe in Form eines Gemisches aus verschiedenen Leuchstoffsubstanzen verwendet werden können, die bei nur einer bestimmten ultravioletten Wellenlänge aktiviert werden, möglich, einzelne Leuchtstoffe und/oder Leuchtstoffe in Form eines Gemisches und/oder Laminats aus verschiedenen Leuchstoffsubstanzen zu verwenden, die gleichzeitig bei voneinander verschiedenen ultravioletten Wellenlängen aktiviert werden und alle zur Bildung eines Spektrums des von der erfindungsgemäßen Lichtquelle abgegebenen sichtbaren Lichts beitragen können. Es kann auf diese Weise der Reichtum an sichtbaren Wellenlängen und/oder Spektren, mit denen ein Spektrum des von der erfindungsgemäßen Lichtquelle erzeugten sichtbaren Lichts zusammengesetzt werden kann, noch einmal beträchtlich vergrößert werden.

Ein derart zusammengesetztes sichtbares Spektrum kann hinsichtlich Komplexität und Variationsmöglichkeit alle sichtbaren Spektren weit übertreffen, die bisher mit aus Leuchtdiode auf Halbleiterbasis und Leuchtstoff bestehenden Lichtquellen und mit einer konventionellen Leuchtstofflampe erzielt wurden, und ermöglicht regelrecht ein Spektrumdesign nach Wunsch. Insbesondere kann weißes Licht mit einem Spektrum erzeugt werden, das gleich dem Spektrum des Sonnenlichts oder diesem zumindest sehr ähnlich ist. Jedenfalls kann weißes Licht einer mit vergleichbaren Lichtquellen nicht erreichbaren Farbtreue erzeugt werden.

Demgemäß besteht eine nicht beanspruchte Ausgestaltung zumindest aus
- einer Diode auf Halbleiterbasis, die ultraviolettes Licht einer Wellenlänge emittiert,
- einem Leuchtstoff, in den das emittierte ultraviolette Licht dieser Wellenlänge einstrahlt und der aus diesem eingestrahlten Licht sichtbares Licht erzeugt,
- einer Diode auf Halbleiterbasis, die ultraviolettes Licht einer anderen Wellenlänge emittiert, die von der einen Wellenlänge verschieden ist, und
- einem Leuchtstoff, in den das emittierte ultraviolette Licht der anderen Wellenlänge einstrahlt und der aus diesem eingestrahlten Licht sichtbares Licht erzeugt.

Der durch das ultraviolette Licht einer Diode aktivierte Leuchtstoff kann prinzipiell der gleiche Leuchtstoff sein, der durch das ultraviolette Licht der anderen Diode aktiviert wird, wenn di.eser ein Leuchtstoff ist, der bei zwei verschiedenen Wellenlängen aktiviert wird. Vorteilhafter ist es jedoch, wenn ein Leuchtstoff, in den ultraviolettes Licht einer Wellenlänge einstrahlt, verschieden ist von einem Leuchtstoff, in den ultraviolettes Licht einer anderen Wellenlänge einstrahlt, die von der einen Wellenlänge verschieden ist.

Bei einer bevorzugten Ausgestaltung einer derartigen Lichtquelle bilden ein Leuchtstoff, in den ultraviolettes Licht einer Wellenlänge einstrahlt, und ein von diesem Leuchtstoff verschiedener Leuchtstoff, in den ultraviolettes Licht einer anderen Wellenlänge einstrahlt, die von der einen Wellenlänge verschieden ist, gemeinsam ein Gemisch und/oder Laminat.

Da das von jeder Diode der Lichtquelle erzeugte ultraviolette Licht unsichtbar ist, hat es vorteilhafterweise keinen farbverfälschenden Einfluß auf das vom Leuchtstoff oder -gemisch erzeugte sichtbare Licht.

Insbesondere kann vermieden werden, daß von der Lichtquelle erzeugtes weißes Licht je nach Betrachtungswinkel leicht gelbstichig oder leicht blaustichig ist.

Ein vom Leuchtstoff nicht absorbierter Anteil des von der Diode erzeugten ultravioletten Lichts kann durch Umhüllung mit einem für ultraviolettes Licht undurchlässigen Kunststoff oder durch Montage hinter Glas vorteilhafterweise einfach ausgefiltert werden.

Vorteilhafterweise kann mit einer erfindungsgemäßen Lichtquelle weißes Licht erzeugt werden, mit dem verschiedenfarbige Objekte, beispielsweise verschiedenfarbige Linien auf Landkarten oder Stadtplänen, besser unterschieden werden können als mit weißem Licht, das von einer bekannten Lichtquelle durch Überlagerung von Licht einer Farbe mit Licht einer anderen Farbe aus einer Leuchtdiode auf Halbleiterbasis erzeugt ist.

Dies beruht auf der Erkenntnis, daß für eine Unterscheidung verschiedenfarbiger Objekte weißes Licht ungünstig ist, das ein aus nur wenigen Linien bestehendes Linienspektrum aufweist. Letzteres ist beispielsweise der Fall, wenn das weiße Licht durch Überlagerung der drei Grundfarben rot, grün und blau erzeugt wird und jede dieser Grundfarben jeweils nur aus einer schmalbandigen Spektrallinie besteht. Verschiedenfarbige Objekte, die ein Spektrum aufweisen, das über die drei schmalbandigen Spektrallinien der Grundfarben hinausgeht, können Farben oder Farbnouancen aufweisen, die bei Beleuchtung mit nur aus den drei schmalbandigen Spektrallinien der Grundfarben gebildetem weißen Licht oftmals nur schwierig oder gar nicht mehr unterschieden werden können.

Es wurde auch erkannt, daß für eine Unterscheidung verschiedenfarbiger Objekte, wenn auch in vergleichsweise geringerem Maße, weißes Licht problematisch sein kann, das durch eine Überlagerung von Licht aus dem gelben Spektralbereich und von blauem Licht gebildet ist.

Die erfindungsgemäße Lichtquelle gemäβ Anspruch 1 kann mit einer einzigen Diode weißes Licht erzeugen, mit dem vorteilhafterweise verschiedenfarbige Objekte mindestens ebensogut unterschieden werden können wie mit weißem Licht, das von einer konventionellen Leuchtstofflampe erzeugt wird.

Im Vergleich mit der bekannten Lichtquelle der eingangs genannten Art aber auch mit der konventionellen Leuchtstofflampe hat die erfindungsgemäße Lichtquelle vorteilhafterweise einen mindestens ebenso hohen Wirkungsgrad und ist im Vergleich mit der bekannten Lichtquelle vorteilhafterweise baulich ebenso einfach, ebenso klein in den Abmessungen, ebenso billig, und benötigt vorteilhafterweise ebenfalls eine nur geringe elektrische Betriebsspannung, die einen Batteriebetrieb ermöglicht.

Bei einer nicht beanspruchten Lichtquelle weist eine Diode eine das ultraviolette Licht emittierende aktive Schicht aus einem Material auf der Basis von AlN und/oder GaN auf. Mit AlN und GaN lassen sich je nach Gehalt an Al und/oder Ga und auch mit Hilfe von Zusatzstoffen prinzipiell alle ultravioletten Wellenlängen, insbesondere die Wellenlängen im Bereich von 150 nm bis 400 nm realisieren. Erfundungsgemäβ sind BₓAl₁₋ₓN, und BₓAl_{y-x}Ga_{y}N wobei x > 0 und der AL-Gehalt mindestens 50% ist. Beispielsweise läßt sich mit reinem ALN die Wellenlänge 200 nm realisieren.

Während AlₓGa₁₋ₓN bei ultraviolettes Licht emittierenden Dioden auf Halbleiterbasis bereits etabliert ist, sind die borhaltigen Nitride BₓAl₁₋ₓN, BₓGa₁₋ₓN und/oder BₓAl_{y-x}Ga_{1-y-x}N bei solchen Dioden bisher unbekannt. Diese borhaltigen Nitride haben den Vorteil, daß sie gitterangepaßt auf Substraten aus SiC aufgewachsen werden können. Der Gehalt an B sollte im Vergleich zum Gehalt an Al und/oder Ga gering sein. Für BₓGa₁₋ₓN und BₓAl₁₋ₓN kann eine Photonenenergie von 5,2 eV bzw. 6,6 eV erwartet werden.

Die von der Gasentladung einer konventionellen Leuchtstofflampe erzeugte Wellenlänge 253,7 nm, die einer Photonenenergie von ungefähr 5 eV entspricht, kann bei einer Lichtquelle erhalten werden, wenn ein für die aktive Schicht verwendetes Al-haltiges Material einen Gehalt an Al von mindestens 50% aufweist. In diesem Fall kann vorteilhafterweise eine Lichtquelle realisiert werden, welche die gleichen aus einzelnen Leuchtstoffsubstanzen oder Gemischen aus mehreren Leuchtstoffsubstanzen bestehenden Leuchtstoffe, die gleichen optischen Eigenschaften und den gleichen hohen Wirkungsgrad wie eine konventionelle Leuchtstofflampe aufweist, die aber im Unterschied zu dieser Lampe vorteilhafterweise eine bedeutend kleinere Abmessung haben und batteriebetrieben sein kann.

Es können bei einer solchen Realisierung vorteilhafterweise alle Leuchtstoffe verwendet werden, wie sie in konventionellen Leuchtstofflampen vorkommen. Diese Leuchtstoffe sind vorteilhafterweise billig und in großen Mengen verfügbar und wurden auf lange Lebensdauer und hohe Effizienz optimiert. Die derzeit auf dem Markt erhältlichen Typen ermöglichen vorteilhafterweise sogar eine gewisse Wahl der Farbtemperatur.

Überdies können bei einer erfindungsgemäßen Lichtquelle gemäβ Anspruch 1 oder 5 vorteilhafterweise neuartige Leuchtstoffe verwendet werden, die neuartige Leuchtstoffsubstanzen einzeln oder in einem Gemisch und/oder Laminat aufweisen. Zur Erzeugung des sichtbaren Lichts sind der gewählte Leuchtstoff und eine Wellenlänge des von der Diode erzeugten ultravioletten Lichts aufeinander abzustimmen, gleichgültig ob der Leuchtstoff konventionell oder neuartig ist.

Jeder in konventionellen Leuchtstofflampen verwendete Leuchtstoff ist für ultraviolettes Licht optimiert, das durch Anregung einer Gasentladung erzeugt ist. Optimiert bedeutet in bezug auf einen Leuchtstoff generell, daß der Leuchtstoff ein Absorptionsmaximum bei derjenigen Wellenlänge aufweist, bei der er zu aktivieren ist. Im Fall der konventionellen Leuchtstofflampen weist jeder optimierte Leuchtstoff ein Absorptionsmaximum bei der Wellenlänge 253,7 nm auf.

Bei einer erfindungsgemäßen Lichtquelle kann vorteilhafterweise eine Steigerung des Wirkungsgrades durch den Einsatz neuer Leuchtstoffe erwartet werden, deren Absorptionsmaximum im nahen Ultraviolettbereich liegt. Dies hat auch den Vorteil, daß Dioden, die ultraviolettes Licht im nahen Ultraviolettbereich, d.h. in der Nähe der Wellenlänge 400 nm emittieren, derzeit besonders einfach hergestellt werden können.

Zur Steigerung des Wirkungsgrades einer ultraviolettes Licht emittierenden Diode ist es zweckmäßig, wenn neben der aktiven Schicht der Diode zumindest eine Schicht aus einem chemischen Stoff angeordnet ist, der im Vergleich zum chemischen Stoff der aktiven Schicht eine größere Bandlücke aufweist. Eine solche Diode kann bei einer erfindungsgemäßen Lichtquelle den Wirkungsgrad der ganzen Quelle erhöhen. Dementsprechend ist es vorteilhaft, wenn eine erfindungsgemäße Lichtquelle eine Diode aufweist, bei der bei der aktiven Schicht zumindest eine Schicht aus einem chemischen Stoff angeordnet ist, der im Vergleich zum chemischen Stoff der aktiven Schicht eine größere Bandlücke aufweist.

Wenn das Material der aktiven Schicht Al-haltig ist, kann die Schicht der größeren Bandlücke dadurch realisiert werden, daß die Schicht der größeren Bandlücke aus einem Al-haltigen Material mit einem im Vergleich zum Material der aktiven Schicht höheren Gehalt an Al besteht.

Wenn das Material der aktiven Schicht B-haltig ist, kann die Schicht der größeren Bandlücke dadurch realisiert werden, daß die Schicht der größeren Bandlücke aus einem B-haltigen Material mit einem im Vergleich zum Material der aktiven Schicht höheren Gehalt an B besteht.

Eine besondere Ausgestaltung einer erfindungsgemäßen Lichtquelle ist gekennzeichnet durch eine Diode, die ultraviolettes Licht bei einer Wellenlänge im Bereich von 150 nm bis 320 emittiert, und einen Leuchtstoff, der daraus sichtbares Licht erzeugt. Ein besonders bevorzugter Bereich der Wellenlänge des ultravioletten Lichts liegt bei 200nm bis 270 nm.

Die erfindungsgemäße Lichtquelle ist baulich sehr einfach, weist neben einem hohen Wirkungsgrad vorteilhafterweise eine lange Lebensdauer auf, benötigt nur eine geringe Betriebsspannung von wenigen Volt und ist miniaturisierbar. Zu ihrer Herstellung können vorteilhafterweise bereits etablierte Technologien verwendet werden.

Die Erfindung wird in der nachfolgenden Beschreibung anhand der Figuren beispielhaft näher erläutert. Es zeigen:
- Figur 1: ein erstes Ausführungsbeispiel einer erfindungsgemäßen Lichtquelle,
- Figur 2: ein zweites Ausführungsbeispiel einer erfindungsgemäßen Lichtquelle.

Die Figuren sind schematisch und nicht maßstäblich.

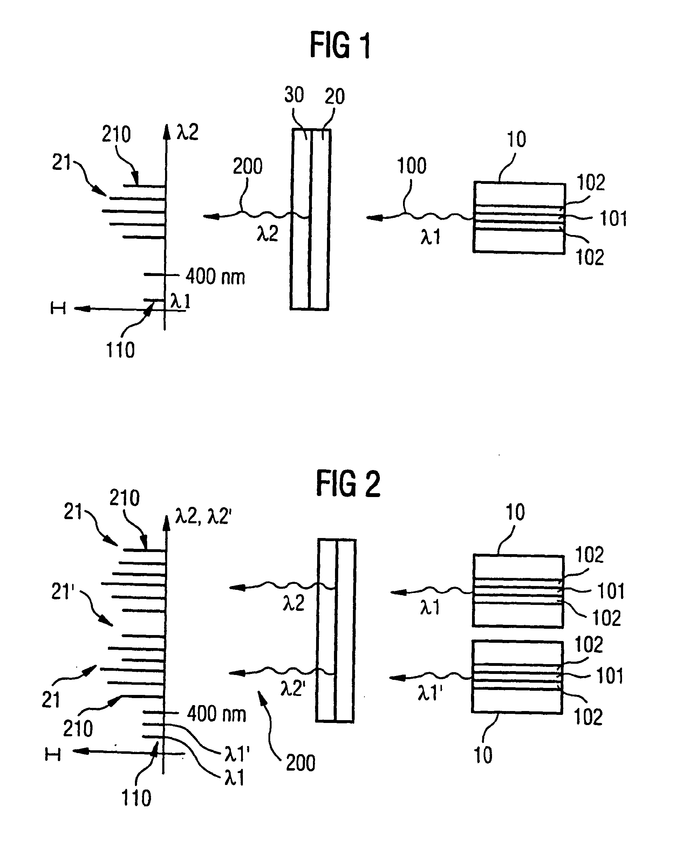

Die in der Figur 1 dargestellte beispielhafte erfindungsgemäße Lichtquelle 1 weist eine Diode 10 auf Halbleiterbasis und einen Leuchtstoff 20 auf. Die Diode 10 emittiert ultraviolettes Licht 100 einer Wellenlänge λ1. Das emittierte ultraviolette Licht 100 strahlt in den Leuchtstoff 20 ein, und der Leuchtstoff 20 erzeugt aus dem eingestrahlten Licht 100 sichtbares Licht 200 einer Wellenlänge λ2.

Der Leuchtstoff 20 kann aus einer einzigen chemischen Leuchtstoffsubstanz bestehen. Das von einer einzigen chemischen Leuchtstoffsubstanz erzeugte sichtbare Licht kann ein Linienspektrum oder ein vergleichsweise breiterbandiges kontinuierliches Spektrum aufweisen.

Das von einer herkömmlichen Diode auf Halbleiterbasis erzeugte sichtbare oder ultraviolette Licht weist stets ein aus einer einzigen Spektrallinie bestehendes Linienspektrum auf.

Das Spektrum 110 des von der Diode 10 bei der Wellenlänge λ1 emittierten ultravioletten Lichts 100 ist demnach auf einen äußerst schmalen, die Wellenlänge λ1 enthaltenden Wellenlängenbereich beschränkt, d.h. nur in diesem schmalen Bereich ist die Intensität I des emittierten ultravioletten Lichts 100 von null verschieden, wobei ein Maximum der Intensität I bei der Wellenlänge λ1 selbst liegt. Äußerlich erscheint dieses Spektrum 110 als eine einzige Linie.

Das Spektrum 210 des von einem aus einer einzigen Leuchtstoffsubstanz bestehenden Leuchtstoff 20 bei der Wellenlänge λ2 emittierten sichtbaren Lichts 200 kann aus einer schmalen Spektrallinie oder einem breiterbandigen kontinuierlichen Spektrum bestehen und weist bei der sichtbaren Wellenlänge λ2 ein Maximum der Intensität I auf.

Anstelle eines aus einer einzigen Leuchtstoffsubstanz bestehenden Leuchtstoffs 20 kann die Lichtquelle 1 auch einen Leuchtstoff 20 aufweisen, der aus zwei oder mehr verschiedene Leuchtstoffsubstanzen besteht, in deren jede das emittierte ultraviolette Licht 100 einstrahlt.

Jede Leuchtstoffsubstanz erzeugt aus diesem Licht 100 sichtbares Licht je eines Spektrums 210, das bei einer jeweils anderen sichtbaren Wellenlänge λ2 ein Maximum der Intensität I aufweist.

Die verschiedenen Leuchtstoffsubstanzen können räumlich voneinander getrennt sein, vorzugsweise bilden sie aber ein Gemisch und/oder Laminat. Die in in den Leuchstoff 20 in Form des Gemisches und/oder Laminats aus mehreren verschiedenen Leuchtstoffsubstanzen eingestrahlte ultraviolette Wellenlänge λ1 erzeugt sichtbares Licht 200 das mehrere Spektren 210 enthält.

In den Figuren 1 und 2 ist jedes solche Spektrum 210 als je eine Linie dargestellt, welche je eine sichtbare Wellenlänge λ2 repräsentiert, bei der dieses Spektrum 210 ein Maximum der Intensität I aufweist.

Die einzelnen Spektren 210 ergeben gemeinsam ein neues Spektrum 21 des von der Lichtquelle 1 abgestrahlten sichtbaren Lichts 200. Durch geeignete Wahl der verschiedenen Leuchtstoffsubstanzen können die einzelnen Spektren 210 nach spektraler Lage und Form so gewählt werden, daß sie gemeinsam ein Spektrum 21 für weißes Licht ergeben.

Die Leuchtstoffsubstanzen des oder der Leuchtstoffe 20 bestehen vorzugsweise aus festen Substanzen, die beispielsweise in Form einer Schicht auf einem Träger 30 aufgebracht sind. Der Träger besteht vorzugsweise aus einem Material, welches für das von dem oder den Leuchtstoffen 20 erzeugte sichtbare Licht 200 durchlässig ist und beispielsweise Glas sein kann.

Die Diode 10 weist eine das ultraviolette Licht 100 emittierende aktive Schicht 101 aus einem Material aus BₓAl₁₋ₓN und/oder BₓAl_{y-x}Ga_{y}N auf, wobei der Gehalt an Al mindestens 50% ist.

Bei einem konkreten Beispiel besteht die aktive Schicht 101 der Diode 10 aus BₓAl_{y-x}Ga_{y}N mit einem Gehalt an Al von 50% bis 60%, wobei der Gehalt an B im Vergleich zum Gehalt an Al gering ist. In dieser aktiven Schicht 101 kann eine Diode 10 realisiert werden, die ultraviolettes Licht 100 bei einer Wellenlänge λ1 im Bereich 150 nm bis 320 nm, vorzugsweise 200 nm bis 320 nm emittiert. In diesen Bereich fällt die Wellenlänge 253,7 nm, welche die Wellenlänge des von der Gasentladung einer konventionellen Leuchtstofflampe erzeugten ultravioletten Lichts ist.

Es kann folglich eine erfindungsgemäße Lichtquelle 1 realisiert werden, die vorteilhafterweise ein genaues erfindungsgemäßes Äquivalent zu einer konventionellen Leuchtstofflampe ist, wenn die Diode 10 so bemessen ist, daß sie ultraviolettes Licht 100 bei der Wellenlänge 253,7 nm emittiert, und wenn ein bei der konventionellen Leuchtstofflampe benutzter herkömmlicher Leuchtstoff verwendet wird, der aus einer einzelnen Leuchtstoffsubstanz oder einem Gemisch und/oder Laminat aus mehreren Leuchtstoffsubstanzen bestehen kann. Gegenüber der konventionellen Leuchtstofflampe hat dessen erfindungsgemäßes Äquivalent die schon genannten beträchtlichen Vorteile.

Bei der aktiven Schicht 101, speziell auf jeder Flachseite der aktiven Schicht 101 ist je eine Schicht 102 aus einem Material angeordnet, das im Vergleich zum Material der aktiven Schicht 101 eine größere Bandlücke aufweist.

Es kann die Schicht 102 der größeren Bandlücke aus einem Al-haltigen Material bestehen, das im Vergleich zum Material der aktiven Schicht 101 einen höheren Gehalt an Al aufweist. Es kann die Schicht 102 der größeren Bandlücke aus einem B-haltigen Material bestehen, das im Vergleich zum Material der aktiven Schicht 101 einen höheren Gehalt an B aufweist.

Beispielsweise kann die aktive Schicht 101 aus BₓAl₁₋ₓN und/oder BₓAl_{y-x}GayN und die Schicht 102 der größeren Bandlücke ebenfalls aus BₓAl₁₋ₓN und/oder BₓAl_{y-x}GayN bestehen, wobei der Gehalt an Al des Materials der Schicht 102 im Vergleich zur aktiven Schicht 101 um so viel höher gewählt ist, daß die Schicht 102 eine größere Bandlücke als die aktive Schicht 101 aufweist.

Beim Ausführungsbeispiel nach Figur 1 weist die Lichtquelle 1 nur eine Diode 10 auf. Diese Diode 10 erzeugt ultraviolettes Licht 100 einer Wellenlänge λ1. Wird ein aus einer einzigen Leuchtstoffsubstanz bestehender Leuchtstoff 20 verwendet, erzeugt dieser aus dem ultravioletten Licht 100 der Wellenlänge λ1 sichtbares Licht 200 mit einem Spektrum 210 bei einer sichtbaren Wellenlänge λ2.

Wird dagegen ein Leuchtstoff 20 in Form eines Gemischs und/oder Laminats aus zwei oder mehreren verschiedenen Leuchtstoffsubstanzen derart verwendet, daß jede Leuchtstoffsubstanz aus dem eingestrahlten ultravioletten Licht 100 der Wellenlänge λ1 sichtbares Licht mit einem Spektrum 210 bei je einer anderen Wellenlänge λ2 erzeugt, so daß die von verschiedenen Leuchtstoffsubstanzen erzeugten Wellenlängen λ2 verschieden voneinander sind, enthält das von der Lichtquelle 1 abgestrahlte sichtbare Licht 200 ein Spektrum 21, das aus einer Anzahl Spektren 210 zusammengesetzt ist, die bei den verschiedenen sichtbaren Wellenlängen λ2 liegen, wobei die Anzahl der Spektren 210 gleich der Anzahl der verschiedenen Leuchtstoffsubstanzen des Gemischs und/oder Laminats ist. Das Spektrum 21 kann aus mehreren einzelnen Spektrallinien, einem oder mehreren kontinuierlichen Spektren oder einem Gemisch aus einer oder mehreren einzelnen Spektrallinien und einem oder mehreren mehreren kontinuierlichen Spektren bestehen.

Das Spektrum 21 aus der Anzahl Spektren 210, die bei verschiedenen sichtbaren Wellenlängen λ2 liegen, kann insoweit noch individuell eingestellt werden, als das Maximum der Intensität I jedes bei einer sichtbaren Wellenlänge λ2 liegenden einzelnen Spektrums 210 durch Verändern des Anteils der dieses Spektrum 210 erzeugenden einzelnen Leuchtstoffsubstanz am Gemisch oder Laminat innerhalb gewisser Grenzen eingestellt werden kann.

Es kann auf diese Weise sichtbares insbesondere weißes Licht 200 erzeugt werden, das zumindest die Qualität des sichtbaren Lichts einer konventionellen Leuchtstofflampe hat. Gegenüber der konventionellen Leuchtstofflampe besteht aber der Vorteil der freien Wahl der aktivierenden ultravioletten Wellenlänge λ1 in einem großen Wellenlängenbereich.

Das Ausführungsbeispiel nach Figur 2 unterscheidet sich vom Beispiel nach Figur 1 im wesentlichen dadurch, daß die Lichtquelle 1 zusätzlich zur Diode 10 eine Diode 10 aufweist, die ultraviolettes Licht 100 einer weiteren Wellenlänge λ1' emittiert, die von der einen ultravioletten Wellenlänge λ1 verschieden ist. Überdies weist die Lichtquelle 1 einen Leuchtstoff 20 auf, in den das ultraviolette Licht 100 der Wellenlänge λ1' einstrahlt und der aus diesem eingestrahlten Licht 100 sichtbares Licht eines Spektrums 210 mit einem Maximum der Intensität I bei einer sichtbaren Wellenlänge λ2' erzeugt, die von der sichtbaren Wellenlänge λ2 verschieden ist. Das von dieser Lichtquelle 1 abgegebene sichtbare Licht 200 enthält somit zumindest ein Spektrum 210, dessen Maximum der Intensität I bei der sichtbaren Wellenlänge λ2 liegt, und zumindest ein Spektrum 210, dessen Maximum der Intensität I bei der sichtbaren Wellenlänge λ2' liegt.

Die Lichtquelle 1 kann zusätzlich zur Diode 10, die das ultraviolette Licht der Wellenlänge λ1 emittiert, auch zwei oder mehr Dioden 10 aufweisen, deren jede ultraviolettes Licht 100 bei je einer anderen Wellenlänge λ1' emittiert, so daß die von verschiedenen Dioden 10 emittierten Wellenlänge λ1' verschieden voneinander sind. In diesem Fall soll die Lichtquelle 1 für jede der verschiedenen ultravioletten Wellenlängen λ1 und λ1' einen Leuchtstoff 20 aufweisen, in den diese ultraviolette Wellenlänge λ1 bzw. λ1' einstrahlt und der aus dieser Wellenlänge λ1 bzw. λ1' sichtbares Licht einer Wellenlänge λ2 bzw. λ2' erzeugt, vorzugsweise derart, daß die von verschiedenen ultravioletten Wellenlängen λ1 bzw λ1' erzeugten Spektren 210 ein bei verschiedenen sichtbaren Wellenlängen λ2 bzw. λ2' liegendes Maximum der Intensität I aufweisen. Das von dieser Lichtquelle 1 abgegebene sichtbare Licht 200 enthält in diesem Fall ein Spektrum 210 mit einem Maximum der Intensität I bei der sichtbaren Wellenlänge λ2 und mehrere Spektren 210 mit jeweils einem Maximum der Intensität I, das bei den zwei oder mehreren voneinander verschiedenen sichtbaren Wellenlängen λ2' liegt.

Für die voneinander verschiedenen ultravioletten Wellenlängen λ1, λ1' kann prinzipiell ein aus einer einzigen chemischen Substanz bestehender Leuchtstoff 20 vorhanden sein, vorausgesetzt, die Substanz weist die Eigenschaft auf, daß sie bei jeder dieser Wellenlängen λ1, λ1' aktiviert wird. Dies ist nicht immer realisierbar.

Vorteilhafter ist es, wenn für jede der verschiedenen ultravioletten Wellenlängen λ1, λ1' je ein individuell zugeordneter Leuchtstoff 20 verwendet wird. Die Leuchtstoffe 20 können in diesem Fall unabhängig voneinander gewählt werden und dadurch sind bedeutend mehr Möglichkeiten zur Realisierung von Spektren 210 bei sichtbaren Wellenlängen λ2, λ2' gegeben, die in dem von der Lichtquelle 1 abgestrahlten Licht 200 enthalten sind.

Insbesondere kann für zumindest eine der verschiedenen ultravioletten Wellenlängen λ1, λ1' ein individuell zugeordneter Leuchtstoff 20 in Form eines Gemischs und/oder Laminats, das aus einer Anzahl von zwei oder mehreren verschiedenen Leuchtstoffsubstanzen besteht, verwendet werden, deren jede nur von dieser ultravioletten Wellenlänge aktiviert wird und die zusammen ein Spektrum 21 aus der gleichen Anzahl Spektren 210 erzeugen, die bei verschiedenen sichtbaren Wellenlängen liegen. Dieses Spektrum 21 ist dieser ultravioletten Wellenlänge und diesem Leuchtstoff 20 allein zugeordnet. Das von der Lichtquelle 1 abgegebene sichtbare Licht 200 enthält dieses Spektrum 21.

Wird für jede der verschiedenen ultravioletten Wellenlängen λ1, λ1' je ein individuell zugeordneter Leuchtstoff 20 jeweils in Form eines dieser Wellenlänge allein zugeordneten Gemischs und/oder Laminats, das aus einer Anzahl von zwei oder mehreren verschiedenen Leuchtstoffsubstanzen besteht, verwendet, deren jede nur von dieser ultravioletten Wellenlänge aktiviert wird und die zusammen eine gleiche Anzahl Spektren 210 bei verschiedenen sichtbaren Wellenlängen erzeugen, die gemeinsam ein Spektrum 21 bilden, das dieser jeweiligen ultravioletten Wellenlänge und diesem jeweiligen Leuchtstoff 20 allein zugeordnet ist, besteht das von der Lichtquelle 1 abgegebene sichtbare Licht 200 aus einer Anzahl solcher Spektren 21, die gleich der gegebenen Anzahl der verschiedenen ultravioletten Wellenlängen λ1, λ1' ist.

Dabei besteht der besondere Vorteil, daß jedes einzelne Spektrum 21 innerhalb gewisser Grenzen individuell einstellbar ist.

Von der Lichtquelle 1 erzeugtes sichtbares Licht 200, das diese Spektren 21 enthält, weist ein aus diesen Spektren 21 bestehendes Superspektrum 21' auf, dessen Komplexität und Variationsmöglichkeit alle Spektren weit übertrifft, die bisher mit aus Leuchtdiode auf Halbleiterbasis und Leuchtstoff bestehenden Lichtquellen und mit konventionellen Leuchtstofflampen erzielt wurden, und das regelrecht ein Spektrumdesign nach Wunsch bietet.

Die zwei oder mehreren Dioden 10 der Lichtquelle 1 nach Figur 2 können voneinander getrennt angeordnet oder alternativ dazu auf einem gemeinsamen, nicht dargestellten Substrat integriert sein, beispielsweise so, daß sie gemeinsam wie eine einzige Diode 10 wirken, die ultraviolettes Licht 100 abstrahlt, das ein aus mehreren verschiedenen ultravioletten Wellenlängen λ1, λ1' bestehendes Linienspektrum aufweist.

Da überdies die den verschiedenen ultravioletten Wellenlängen λ1, λ1' individuell zugeordneten Leuchtstoffe 20 gemeinsam ein einziges Gemisch und/oder Laminat bilden können, kann auch die Lichtquelle 1 nach Figur 2 miniaturi-, siert sein, wobei sie alle sonstigen erwähnten Vorteile einer erfindungsgemäßen Lichtquelle beibehält.

## Patentansprüche

1. Lichtquelle (1) zur Erzeugung sichtbaren Lichts (200),
mit
- zumindest einer ultraviolettes Licht (100) emittierenden Diode (10) auf Halbleiterbasis und
- zumindest einem Leuchtstoff (20), in den das emittierte ultraviolette Licht (100) einstrahlt und der aus dem emittierten ultravioletten Licht (100) das sichtbare Licht (200) erzeugt,
**dadurch gekennzeichnet, daß**
- die das ultraviolette Licht (100) emittierende aktive Schicht (101) der Diode (10) aus einem Material besteht, das aus der aus BₓAl₁₋ₓN und BₓAl_{y-x}Ga_{y}N bestehenden Gruppe ausgewählt ist,
wobei x > 0 und der Al-Gehalt mindestens 50% ist.

2. Lichtquelle nach Anspruch 1, **dadurch gekennzeichnet, daß** bei der aktiven Schicht (101) zumindest eine Schicht (102) aus einem Material angeordnet ist, das im Vergleich zum Material der aktiven Schicht (101) eine größere Bandlücke aufweist.

3. Lichtquelle nach Anspruch 2, **dadurch gekennzeichnet, daß** die Schicht (102) der größeren Bandlücke aus einem Al-haltigen Material mit einem im Vergleich zum Material der aktiven Schicht (101) höheren Gehalt an Al besteht.

4. Lichtquelle nach Anspruch 2 oder 3, **dadurch gekennzeichnet, daß**
die Schicht (102) der größeren Bandlücke aus einem B-haltigen Material mit einem im Vergleich zum Material der aktiven Schicht (101) höheren Gehalt an B besteht.

5. Lichtquelle (1) zur Erzeugung
von sichtbarem Licht mit einer ersten und
einer zweiten nicht sichtbare Strahlung emittierenden Diode auf Halbleiterbasis und einem ersten und einem zweiten Leuchtstoff,
**dadurch gekennzeichnet, daß**
- die erste Diode (10) ultraviolettes Licht (100) einer ersten Wellenlänge (λ1) emittiert,
- der erste Leuchtstoff (20), in den das emittierte ultraviolette Licht (100) der ersten Wellenlänge (λ1) einstrahlt, aus diesem eingestrahlten Licht (100) sichtbares Licht (200) erzeugt,
- die zweite Diode (10) ultraviolettes Licht (100) einer zweiten Wellenlänge (λ1') emittiert, die von der ersten Wellenlänge (λ1) verschieden ist,
- der zweite Leuchtstoff (20), in den das emittierte ultraviolette Licht (100) der zweiten Wellenlänge (λ1') einstrahlt, aus diesem eingestrahlten Licht (100) sichtbares Licht (200) erzeugt, und
- die aktive Schicht (101) einer Diode Material aufweist, das aus der aus BₓAl₁₋ₓN und BₓAl_{y-x}GayN bestehenden Gruppe ausgewählt ist, wobei x > 0 und der Al-Gehalt mindestens 50% ist.

6. Lichtquelle nach Anspruch 5,
**dadurch gekennzeichnet, daß**
der erste Leuchtstoff (20) vom zweiten Leuchtstoff verschieden ist.

7. Lichtquelle nach Anspruch 6,
**dadurch gekennzeichnet, daß**
der erste Leuchtstoff (20) und der zweite Leuchtstoff (20) gemeinsam ein Gemisch und/oder Laminat bilden.

8. Lichtquelle nach einem der Ansprüche 5 bis 7,
**dadurch gekennzeichnet, daß**
bei der aktiven Schicht (101) zumindest eine Schicht (102) aus einem Material angeordnet ist, das im Vergleich zum Material der aktiven Schicht (101) eine größere Bandlücke aufweist.

9. Lichtquelle nach einem der vorhergehenden Ansprüche, **gekennzeichnet durch** einen Gehalt der aktiven Schicht an Al von 50% bis 60%.

10. Lichtquelle nach einem der vorhergehenden Ansprüche, **gekennzeichnet durch**
- eine Diode (10), die ultraviolettes Licht (100) bei einer Wellenlänge (λ1, λ1') im Bereich 150nm bis 320nm emittiert.

## Claims

1. Light source (1) for generating visible light (200), comprising
- at least one semiconductor-based diode (10) that emits ultraviolet light (100) and
- at least one phosphor (20) into which the emitted ultraviolet light (100) radiates and which generates the visible light (200) from the emitted ultraviolet light (100)
**characterized in that**
- the active layer (101) of the diode (10), which active layer emits the ultraviolet light (100), consists of a material selected from the group consisting of BₓAl₁₋ₓN and BₓAl_{y-x}Ga_{y}N, where x > 0 and the Al content is at least 50%.

2. Light source according to Claim 1, **characterized in that** at least one layer (102) composed of a material having a larger band gap in comparison with the material of the active layer (101) is arranged at the active layer (101).

3. Light source according to Claim 2, **characterized in that** the layer (102) having the larger band gap consists of an Al-containing material having a higher content of Al in comparison with the material of the active layer (101).

4. Light source according to Claim 2 or 3, **characterized in that** the layer (102) having the larger band gap consists of an B-containing material having a higher content of B in comparison with the material of the active layer (101).

5. Light source (1) for generating visible light comprising a first and a second semiconductor-based diode that emits non-visible radiation, and a first and a second phosphor,
**characterized in that**
- the first diode (10) emits ultraviolet light (100) having a first wavelength (λ1),
- the first phosphor (20), into which the emitted ultraviolet light (100) having the first wavelength (λ1) radiates, generates visible light (200) from this light (100) radiated in,
- the second diode (10) emits ultraviolet light (100) having a second wavelength (λ1'), which differs from the first wavelength (λ1),
- the second phosphor (20), into which the emitted ultraviolet light (100) having the second wavelength (λ1') radiates, generates visible light (200) from this light (100) radiated in, and
- the active layer (101) of a diode comprises material selected from the group consisting of BₓAl₁₋ₓN and BₓAl_{y-x}Ga_{y}N, where x > 0 and the Al content is at least 50%.

6. Light source according to Claim 5,
**characterized in that**
the first phosphor (20) differs from the second phosphor.

7. Light source according to Claim 6,
**characterized in that**
the first phosphor (20) and the second phosphor (20) jointly form a mixture and/or laminate.

8. Light source according to any of Claims 5 to 7, **characterized in that**
at least one layer (102) composed of a material having a larger band gap in comparison with the material of the active layer (101) is arranged at the active layer (101).

9. Light source according to any of the preceding claims, **characterized by** an Al content of the active layer of 50% to 60%.

10. Light source according to any of the preceding claims, **characterized by**
- a diode (10) which emits ultraviolet light (100) at a wavelength (λ1, λ1') in the range of 150 nm to 320 nm.

## Revendications

1. Source de lumière (1) pour générer de la lumière visible (200), comprenant
- au moins une diode (10) à base de semiconducteur qui émet de la lumière ultraviolette (100) et
- au moins un luminophore (20) dans lequel est irradiée la lumière ultraviolette (100) émise et qui génère la lumière visible (200) à partir de la lumière ultraviolette (100) émise,
**caractérisée en ce que**
- la couche active (101) de la diode (10) qui émet la lumière ultraviolette (100) se compose d'un matériau qui est choisi dans le groupe constitué de BₓAl₁₋ₓN et BₓAl_{y-x}GayN, avec x > 0 et la teneur en Al étant d'au moins 50 %.

2. Source de lumière selon la revendication 1, **caractérisée en ce que** près de la couche active (101) est disposée au moins une couche (102) en un matériau qui présente une bande interdite supérieure à celui du matériau de la couche active (101).

3. Source de lumière selon la revendication 2, **caractérisée en ce que** la couche (102) qui possède la bande interdite supérieure se compose d'un matériau contenant de l'Al dont la teneur en Al est supérieure à celle du matériau de la couche active (101).

4. Source de lumière selon la revendication 2 ou 3, **caractérisée en ce que** la couche (102) qui possède la bande interdite supérieure se compose d'un matériau contenant du B dont la teneur en B est supérieure à celle du matériau de la couche active (101).

5. Source de lumière (1) pour générer de la lumière visible comprenant une première et une deuxième diode à base de semiconducteur qui émettent un rayonnement non visible ainsi qu'un premier et un deuxième luminophore,
**caractérisée en ce que**
- la première diode (10) émet de la lumière ultraviolette (100) à une première longueur d'onde (λ1),
- le premier luminophore (20), dans lequel est irradiée la lumière ultraviolette (100) émise à la première longueur d'onde (λ1) génère de la lumière visible (200) à partir de cette lumière (100) irradiée,
- la deuxième diode (10) émet de la lumière ultraviolette (100) à une deuxième longueur d'onde (λ1') qui est différente de la première longueur d'onde (λ1),
- le deuxième luminophore (20), dans lequel est irradiée la lumière ultraviolette (100) émise à la deuxième longueur d'onde (λ1'), génère de la lumière visible (200) à partir de cette lumière (100) irradiée,
et
- la couche active (101) présente un matériau de diode qui est choisi dans le groupe constitué de BₓAl₁₋ₓN et BₓAl_{y-x}Ga_{y}N, avec x > 0 et la teneur en Al étant d'au moins 50 %.

6. Source de lumière selon la revendication 5, **caractérisée en ce que** le premier luminophore (20) est différent du deuxième luminophore.

7. Source de lumière selon la revendication 6, **caractérisée en ce que** le premier luminophore (20) et le deuxième luminophore (20) forment ensemble un mélange et/ou un laminé.

8. Source de lumière selon l'une des revendications 5 à 7, **caractérisée en ce que** près de la couche active (101) est disposée au moins une couche (102) en un matériau qui présente une bande interdite supérieure à celui du matériau de la couche active (101).

9. Source de lumière selon l'une des revendications précédentes, **caractérisée par** une teneur en Al de la couche active de 50 % à 60 %.

10. Source de lumière selon l'une des revendications précédentes, **caractérisée par** une diode (10) qui émet de la lumière ultraviolette (100) à une longueur d'onde (λ1, λ1') dans la plage de 150 nm à 320 nm.
